# EUROPÄISCHE PATENTANMELDUNG

(11) **EP 4 372 800 A1**
(43) Veröffentlichungstag der Anmeldung: **22.05.2024**
(21) Anmeldenummer: 22207779.4
(22) Anmeldetag: 16.11.2022
(51) Int. Cl.: H01L 23/04, H01L 23/10, H01L 23/00, H01L 23/053, H01L 25/07, H01L 23/373

(54) **GEHÄUSE, LEISTUNGSMODUL UND ELEKTRISCHES GERÄT**

(71) Anmelder: Siemens Aktiengesellschaft, 80333 München (DE)
(72) Erfinder: Kürten, Bernd, 90587 Obermichelbach (DE); Namyslo, Lutz, 91353 Hausen (DE); Niessner, Andreas, 90455 Nürnberg (DE)
(74) Vertreter: Siemens Patent Attorneys

(57) **Zusammenfassung**

Die Erfindung betrifft ein Gehäuse (1) für ein Leistungsmodul (30), wobei das Gehäuse (1) bei einer Draufsicht im Wesentlichen rechteckig ausgestaltet ist und einen äußeren Gehäuserahmen (2), einen Verbindungsbereich (3) und einen inneren Gehäuserahmen (4) aufweist, wobei der innere Gehäuserahmen (4) zur Aufnahme und zum zumindest teilweisen Einhausen eine Montagefläche (5) für zumindest ein elektrisches Bauteil (26) des Leistungsmoduls (30) ausgebildet ist und wobei der äußere Gehäuserahmen (2) außerhalb des inneren Gehäuserahmens (4) angeordnet ist und über den Verbindungsbereich (3) mit dem inneren Gehäuserahmen (4) verbunden ist.

Weiterhin betrifft die Erfindung ein Leistungsmodul (30) aufweisend ein derartiges Gehäuse (1) und eine Montagefläche (5) für zumindest ein elektrisches Bauteil (26), wobei die Montagefläche (5) durch den inneren Gehäuserahmen (4) aufgenommen und zumindest teilweise eingehaust wird. Ferner betrifft die Erfindung ein elektrisches Gerät (32), insbesondere einen Umrichter, umfassend zumindest ein derartiges Gehäuse (1) und/oder zumindest ein derartiges Leistungsmodul (30), vorzugsweise zumindest drei derartige Leistungsmodule (30).

Insbesondere um ein verbessertes Gehäuse (1), ein verbessertes Leistungsmodul (30) bzw. ein verbessertes elektrisches Gerät (32) bereitzustellen, wird vorgeschlagen, dass der Verbindungsbereich (3) im Bereich der jeweiligen kurzen Seite (6) jeweils einen abgesetzten Verbindungsbereich (7) aufweist, welcher bei einer Draufsicht unterhalb der oberen Kante (8) des äußeren Gehäuserahmens (2) im Bereich der jeweiligen kurzen Seite (6) angeordnet ist.

## Beschreibung

Die Erfindung betrifft ein Gehäuse für ein Leistungsmodul, wobei das Gehäuse bei einer Draufsicht im Wesentlichen rechteckig ausgestaltet ist und einen äußeren Gehäuserahmen, einen Verbindungsbereich und einen inneren Gehäuserahmen aufweist, wobei der innere Gehäuserahmen zur Aufnahme und zum zumindest teilweisen Einhausen einer Montagefläche für zumindest ein elektrisches Bauteil des Leistungsmoduls ausgebildet ist und wobei der äußere Gehäuserahmen außerhalb des inneren Gehäuserahmens angeordnet ist und über den Verbindungsbereich mit dem inneren Gehäuserahmen verbunden ist.

Weiterhin betrifft die Erfindung ein Leistungsmodul aufweisend ein derartiges Gehäuse und eine Montagefläche für zumindest ein elektrisches Bauteil, wobei die Montagefläche durch den inneren Gehäuserahmen aufgenommen und zumindest teilweise eingehaust wird.

Schließlich betrifft die Erfindung ein elektrisches Gerät, insbesondere einen Umrichter, umfassend zumindest ein derartiges Gehäuse und/oder zumindest ein derartiges Leistungsmodul, vorzugsweise zumindest drei derartige Leistungsmodule.

Derartige Vorrichtungen kommen in einer Vielzahl von Anwendungen in der Leistungselektronik zum Einsatz. Dabei dienen die Gehäuse, oftmals Terminal-Gehäuse genannt, für Leistungsmodule dazu, eine sichere und dauerhafte Verbindung zwischen Leistungs-Halbleiterchips und einer Leiterplatte herzustellen. Die Verbindung zwischen den Halbleiterchips und den Terminals erfolgt oftmals über Bonddrähte oder -Bändchen mit einem Durchmesser von ca. 75 µm bis 600 µm, bzw. einer Breite von 0,5 mm bis 3 mm. Im weiteren Text wird zur Vereinfachung nur von Bonddrähten und Drahtbonden gesprochen. Die Befestigung der Drähte sowohl auf dem Chip als auch auf den Terminals kann durch (Dickdraht-) Ultraschallbonden bzw. Ultraschallschweißen, das heißt insbesondere durch eine Ultraschallverbindungstechnik erfolgen. Die Ultraschallfrequenz liegt, abhängig vom verwendeten Bondautomaten und dem Bondkopf, im Bereich von 10 kHz bis 150 kHz und ist in der Regel nicht veränderbar.

Mit der Ultraschallfrequenz können während des Bondvorgangs bzw. des Verbindens mit einer Ultraschallverbindungstechnik die Eigenfrequenzen des Terminal-Gehäuses angeregt werden. Die Eigenfrequenzen werden durch die Größe, die Strukturen und die Materialeigenschaften, z.B. die Steifheit, des Gehäuses definiert. Ist die Schwingung ungenügend gedämpft, kommt es zum Aufschwingen durch einen Resonanzeffekt. In diesem Fall wird die Bondverbindung teils nur mit ungenügender Festigkeit hergestellt, so dass sich der Bonddraht später zu einem beliebigen Zeitpunkt während des Betriebs lösen kann, oder im Extremfall fällt der Draht bereits nach dem Bondvorgang ab.

Dieses Problem kann unter folgenden Randbedingungen verstärkt auftreten:
- Die Pins sind fest mit dem Terminal-Gehäuse verbunden, z.B. durch Umspritzen, im Gegensatz zu gesteckten Pins, die zum Teil noch verklebt sind.
- Das Terminal-Gehäuse ist aus Kunststoff gefertigt, der sehr steif ist, z.B. Polyphenylensulfid (kurz PPS)-Material. Die hohe Steifigkeit kann beispielsweise aufgrund eines hohen Glasfaseranteils vorhanden sein, der eine höhere Hitzebeständigkeit gewährleisten soll. Diese Anforderung ergibt sich durch die Erhöhung der zulässigen maximalen Chiptemperatur von ursprünglich 150°C auf 175°C oder mehr in den letzten Jahren.
- Die Verschraubungsstellen des Terminal-Gehäuses, die gleichzeitig die Haltepunkte beim Bondvorgang sind, befinden sich nicht an den Ecken und außerhalb der Fluchtlinien der Pins.
- Die Gehäusegeometrie ist in Bezug der Pins auf der Längs- und Querseite unsymmetrisch.
- Um die Pins vor dem Umspritzen in das Werkzeug einzuführen, ist im Werkzeug Platz notwendig, der die Designfreiheiten einschränkt.
- Um die Pins während des Spritzvorgangs sicher zu halten, sind Klemmmechanismen im Werkzeug vorzusehen, die die Designfreiheiten ebenfalls einschränken.
- Um das Auswerfen des Terminalgehäuses nach erfolgtem Spritzvorgang sicher zu gewährleisten, sind eine ausreichende Anzahl an Auswerfern vorzusehen, die weitere Designeinschränkungen mit sich bringen.

Die Anregung von Resonanzen während des Bondvorgangs ist ein bekanntes Problem beim Drahtbonden. Insbesondere bei der Verwendung von dickeren Drähten mit Durchmessern von 400 µm bis 500 µm wird das Problem verstärkt, da höhere Andruckkräfte und Ultraschalleistungen angewendet werden, die damit zu einer stärkeren Anregung führen.

Eine Aufgabe der Erfindung ist es, ein verbessertes Gehäuse, ein entsprechendes Leistungsmodul und ein entsprechendes elektrisches Gerät bereitzustellen, welches insbesondere die oben erläuterten Nachteile überwindet und beispielsweise eine sichere und dauerhafte Verbindung von gebondeten, elektrischen Verbindungen innerhalb des Leistungsmoduls erleichtert.

Eine Lösung der Aufgabe ergibt sich durch ein Gehäuse der eingangs genannten Art dadurch, dass der Verbindungsbereich im Bereich der jeweiligen kurzen Seite jeweils einen abgesetzten Verbindungsbereich aufweist, welcher bei einer Draufsicht unterhalb der oberen Kante des äußeren Gehäuserahmens im Bereich der jeweiligen kurzen Seite angeordnet ist.

Eine weitere Lösung der Aufgabe ergibt sich durch ein Leistungsmodul der eingangs genannten Art dadurch, dass das Leistungsmodul das vorgeschlagene Gehäuse und eine Montagefläche für zumindest ein elektrisches Bauteil aufweist, wobei die Montagefläche durch den inneren Gehäuserahmen aufgenommen und zumindest teilweise eingehaust wird.

Eine zusätzliche Lösung der Aufgabe ergibt sich durch ein elektrisches Gerät der eingangs genannten Art dadurch, dass das elektrische Gerät das vorgeschlagene Gehäuse und/oder das vorgeschlagene Leistungsmodul, vorzugsweise zumindest drei der vorgeschlagenen Leistungsmodule, aufweist.

Die Montagefläche kann beispielsweise als eine Metallplatte, eine flache Oberfläche eines Kühlkörpers oder ein Substrat ausgestaltet sein. Bei dem Substrat kann es sich bspw. um ein DCB(Direct Copper Bonded)-Substrat oder um ein AMB(Active Metal Brazing)-Substrat handeln. In manchen Beispielen kann auch eine Leiterplatte (printed circuit board, PCB) als Substrat verwendet werden. Weiterhin kann das Substrat bzw. allgemein die Montagefläche auch zweistückig oder mehrstückig ausgestaltet sein. Dabei kann das jeweilige elektrische Bauteil direkt auf der Montagefläche montiert sein. Denkbar ist auch ein bodenloses Gehäuse bzw. Leistungsmodul.

Bei einer Draufsicht auf das Gehäuse ist das Gehäuse im Wesentlichen rechteckig ausgestaltet. Beispielsweise kann auch die Montagefläche bzw. das Substrat als flache Platte bzw. als flacher Quader ausgestaltet sein kann. Somit weist das Gehäuse bzw. auch die Montagefläche bei einer Draufsicht zwei, sich gegenüberliegende kurze Seiten und zwei, sich ebenfalls gegenüberliegende lange Seiten auf. Ist das Gehäuse bzw. die Montagefläche dabei zweistückig oder mehrstückig ausgestaltet, kann bspw. auch das/die aus den zwei oder mehr Montageflächen bzw. Substratstücken gebildete Gehäuse bzw. Montagefläche den bei einer Draufsicht im wesentlichen rechteckigen Grundriss aufweisen. Insbesondere wird bei der Draufsicht auf das Gehäuse bzw. die Montagefläche auf die Oberseite des Gehäuses bzw. der Montagefläche geblickt, wobei auf der Oberseite der Montagefläche bspw. elektrische Bauteile, insbesondere Leistungshalbleiter bzw. Transistoren, angeordnet sind.

Zur Aufnahme der Montagefläche weist das Gehäuse insbesondere den inneren Gehäuserahmen auf, welcher über den Verbindungsbereich mit dem äußeren Gehäuserahmen verbunden ist. Bspw. können dabei der innere Gehäuserahmen, der Verbindungsbereich und der äußere Gehäuserahmen bzw. zumindest zwei dieser Elemente einstückig ausgeführt sein.

Der Verbindungsbereich ist zumindest im Bereich der beiden, oben erläuterten, kurzen Seiten vorhanden und kann darüber hinaus auch im Bereich der beiden, oben erläuterten, langen Seiten vorhanden sein. In manchen Beispielen weist das Gehäuse im Bereich der langen Seite jedoch keinen separaten Verbindungsbereich auf. Im Bereich der beiden kurzen Seiten weist der Verbindungsbereich jeweils einen abgesetzten Verbindungsbereich auf. Ebenfalls im Bereich der beiden kurzen Seiten weist der äußere Gehäuserahmen bei einer Draufsicht eine obere Kante auf. D. h., spannt die Montagefläche eine x-y-Ebene auf, dann erstreckt sich der äußere Gehäuserahmen im Bereich der jeweiligen kurzen Seite insb. in z-Richtung, wobei die Oberseite der Montagefläche in positiver z-Richtung weist und die Unterseite der Montagefläche in negativer z-Richtung weist. Die obere Kante des äußeren Gehäuserahmens im Bereich der jeweiligen kurzen Seite entspricht dann dem obersten Punkt des äußeren Gehäuserahmens in positiver z-Richtung und analog entspricht die untere Kante des äußeren Gehäuserahmens im Bereich der jeweiligen kurzen Seite dem untersten Punkt des äußeren Gehäuserahmens in negativer z-Richtung.

Dabei ist dieser jeweilige abgesetzte Verbindungsbereich unterhalb der oberen Kante des äußeren Gehäuserahmens angeordnet. In anderen Worten überragt der äußere Gehäuserahmen im Bereich der jeweiligen kurzen Seite also den jeweiligen abgesetzten Verbindungsbereich in positiver z-Richtung.

Insbesondere dank dem erläuterten abgesetzten Verbindungsbereich kann ein Aufschwingen des Gehäuses während des Bondens bzw. Verbindens mittels einer Ultraschallverbindungstechnik von Bauteilen des Leistungsmoduls verringert bzw. verhindert werden, so dass eine sichere und dauerhafte Verbindung von gebondeten, elektrischen Verbindungen innerhalb des Leistungsmoduls erleichtert wird.

Bei einer vorteilhaften Ausgestaltung der der Erfindung ist der abgesetzte Verbindungsbereich bei einer Draufsicht oberhalb der unteren Kante des äußeren Gehäuserahmens im Bereich der jeweiligen kurzen Seite angeordnet.

Der jeweilige abgesetzte Verbindungsbereich ist somit oberhalb der unteren Kante des äußeren Gehäuserahmens angeordnet. In anderen Worten überragt der äußere Gehäuserahmen im Bereich der jeweiligen kurzen Seite also den jeweiligen abgesetzten Verbindungsbereich auch in negativer z-Richtung.

Auch diese Ausgestaltung des abgesetzten Verbindungsbereichs bzw. des Gehäuses trägt dazu bei, ein Aufschwingen des Gehäuses während des Bondens bzw. Verbindens mittels einer Ultraschallverbindungstechnik von Bauteilen des Leistungsmoduls zu verringern bzw. zu verhindern, so dass eine sichere und dauerhafte Verbindung von gebondeten, elektrischen Verbindungen innerhalb des Leistungsmoduls erleichtert wird.

Bei einer weiteren vorteilhaften Ausgestaltung der Erfindung weist das Gehäuse mehrere Anschlusspins auf, wobei der jeweilige Anschlusspin an seinem unteren Ende eine jeweilige Anschlusspin-Kontaktfläche aufweist, über welche der jeweilige Anschlusspin mittels eines Bonddrahtes und mittels Bonden mit der Montagefläche verbindbar ist, und wobei der abgesetzte Verbindungsbereich jeweils senkrecht zur Ebene der Montagefläche überwiegend in einem Höhenbereich um die Höhe der jeweiligen Anschlusspin-Kontaktfläche angeordnet ist.

Beispielsweise kann das Gehäuse Aussparungen im Bereich der langen Seiten aufweisen, wobei die Aussparungen quaderförmig oder zylindrisch ausgestaltet sein können. In einer der Aussparungen kann jeweils ein Anschlusspin angebracht werden. Der jeweilige Anschlusspin kann alternativ auch umspritzt werden, so dass das Gehäuse keine Aussparung zur Aufnahme des jeweiligen Anschlusspins aufweisen muss. An seinem unteren Ende weist der jeweilige Anschlusspin eine Anschlusspin-Kontaktfläche auf. Insbesondere mittels eines Bonddrahtes kann der jeweilige Anschlusspin mit der Montagefläche elektrisch verbunden werden, wozu insbesondere Bonden bzw. eine Ultraschallverbindungstechnik als Verbindungstechnik zum Einsatz kommen kann.

Die jeweilige Anschlusspin-Kontaktfläche ist dabei senkrecht zur Ebene der Montagefläche betrachtet in einer bestimmten Höhe angeordnet, wobei der abgesetzte Verbindungsbereich überwiegend in einem Höhenbereich um diese Höhe herum angeordnet ist. In dem oben erläuterten Beispiel, in welchem die Montagefläche eine x-y-Ebene aufspannt, befindet sich somit die jeweilige Anschlusspin-Kontaktfläche in einer Höhe, welche einem bestimmten Wert in z-Richtung entspricht, und befindet sich der abgesetzte Verbindungsbereich überwiegend in einem Höhenbereich in z-Richtung, welcher um die genannte Höhe bzw. den bestimmten Wert in z-Richtung angeordnet ist.

Bei einer weiteren vorteilhaften Ausgestaltung der Erfindung beträgt dabei der Höhenbereich ± 20 mm, insb. ± 10 mm oder ± 5 mm, und/oder erstreckt sich der Höhenbereich über drei Viertel, insb. die Hälfte oder ein Viertel, der Erstreckung des äußeren Gehäuserahmens in einer Richtung senkrecht zur Ebene der Montagefläche.

In dem oben erläuterten Beispiel, in welchem die Montagefläche eine x-y-Ebene aufspannt, erstreckt sich somit der Höhenbereich in z-Richtung. Somit entspricht die Richtung senkrecht zur Ebene der Montagefläche der z-Richtung. Dabei kann sich der Höhenbereich bspw. ± 10 mm um die Höhe in z-Richtung der jeweiligen Anschlusspin-Kontaktfläche erstrecken. Insbesondere erstreckt sich der Höhenbereich über ein Viertel der Erstreckung des äußeren Gehäuserahmens in z-Richtung, wobei hierbei insbesondere die Erstreckung des äußeren Gehäuserahmens im Bereich der jeweiligen kurzen Seite gemeint ist.

Besonders gute Ergebnisse lassen sich dabei mit einem Höhenbereich von ± 10 mm bzw. einem Viertel der Erstreckung des äußeren Gehäuserahmens in z-Richtung erzielen.

Bei einer weiteren vorteilhaften Ausgestaltung der Erfindung ist das Gehäuse bei einer Draufsicht unterhalb des Verbindungsbereichs und des inneren Gehäuserahmens zur Aufnahme einer Bodenplatte oder eines Kühlelements ausgebildet, wobei der jeweilige abgesetzte Verbindungsbereich einen Stützabschnitt aufweist, welcher die aufgenommene Bodenplatte bzw. den aufgenommenen Kühlkörper berührt bzw. mit dieser bzw. diesem verbunden ist.

Die Bodenplatte wird somit unter der Montagefläche angeordnet, d. h., von unten nach oben bzw. von negativer z-Richtung zur positiven z-Richtung hin sind dann zunächst die Bodenplatte, dann die Montagefläche und dann optional die auf der Montagefläche angeordneten elektrischen Bauteile, insbesondere Leistungshalbleiter, angeordnet.

Die Bodenplatte kann dabei von dem Gehäuse aufgenommen werden, bspw. indem der innere Gehäuserahmen die Bodenplatte stützt bzw. mit der Bodenplatte verbunden ist. Zur Aufnahme der Bodenplatte durch das Gehäuse weist der jeweilige, abgesetzte Verbindungsbereich einen Stützabschnitt auf, welcher die aufgenommene Bodenplatte berührt oder mit diesem (z.B. über Kleber) verbunden ist. Über den Stützabschnitt kann somit der abgesetzte Verbindungsbereich die Bodenplatte zumindest teilweise fixieren bzw. halten. Neben der Stützung der Bodenplatte hat der Stützabschnitt den Vorteil, dass eine Krafteinleitung aus dem abgesetzten Verbindungsbereich in die Bodenplatte erzielt werden kann, welche möglicherweise beim Bonden auftretende Schwingungen dämpfen kann. Somit kann auch der jeweilige Stützabschnitt dazu beitragen, dass eine sichere und dauerhafte Verbindung von gebondeten, elektrischen Verbindungen innerhalb des Leistungsmoduls erleichtert wird. Dabei kann die Bodenplatte als Kühlkörper ausgestaltet sein, welcher bspw. Kühlrippen oder -pins aufweist oder Heatpipes umfasst.

Bei einer weiteren vorteilhaften Ausgestaltung der Erfindung ist dabei der jeweilige Stützabschnitt an jenem Ende des abgesetzten Verbindungsbereichs angeordnet, welches dem äußeren Gehäuserahmen zugewandt ist.

Besonders gute Ergebnisse bezüglich der Dämpfung von während des Bondens auftretenden Schwingungen lassen sich erzielen, indem der jeweilige Stützabschnitt an dem, dem äußeren Gehäuserahmen zugewandten Ende des abgesetzten Verbindungsbereich angeordnet ist.

Bei einer weiteren vorteilhaften Ausgestaltung der Erfindung ist der jeweilige abgesetzte Verbindungsbereich vom inneren Gehäuserahmen zum äußeren Gehäuserahmen bei einer Draufsicht auf die Montagefläche zumindest abschnittsweise abfallend oder ansteigend geneigt.

Die Neigung bedeutet dabei insbesondere, dass der jeweilige abgesetzte Verbindungsbereich sich vom inneren Gehäuserahmen zum äußeren Gehäuserahmen hin entweder in positiver z-Richtung erhebt oder in negativer z-Richtung absenkt. Die Neigung liegt dabei also insbesondere ausgehend von der oben erwähnten x-y-Ebene, welche durch die Montagefläche aufgespannt wird, in Richtung der positiven oder negativen z-Richtung vor.

Die zumindest abschnittsweise geneigte Ausgestaltung des jeweiligen abgesetzten Verbindungsbereiches kann insbesondere zu einer Versteifung des Gehäuses führen, welche beim Bonden auftretende Schwingungen dämpfen kann oder bspw. in höhere Resonanzfrequenzen verschieben kann, welche für den Bondprozess bzw. den Ultraschallverbindungsprozess unkritisch sind.

In manchen Beispielen ist der jeweilige abgesetzte Verbindungsbereich dabei durchgängig abfallend oder ansteigend geneigt. Denkbar ist dabei weiterhin, dass der jeweilige abgesetzte Verbindungsbereich vom inneren Gehäuserahmen zum äußeren Gehäuserahmen hin ansteigende und abfallende Abschnitte aufweist.

Besonders gute Ergebnisse bezüglich der Dämpfung von während des Bondens bzw. des Verbindens mittels einer Ultraschallverbindungstechnik auftretenden Schwingungen lassen sich erzielen, indem der jeweilige abgesetzte Verbindungsbereich vom inneren Gehäuserahmen zum äußeren Gehäuserahmen hin abfallend geneigt ist, d.h., sich in negativer z-Richtung absenkt.

Bei einer weiteren vorteilhaften Ausgestaltung der Erfindung beträgt die Neigung des jeweiligen abgesetzten Verbindungsbereichs zwischen 3° und 30°, vorzugsweise zwischen 5° und 15°, insbesondere ca. 9°.

Besonders gute Ergebnisse bezüglich der Dämpfung von während des Bondens auftretenden Schwingungen lassen sich erzielen, indem der jeweilige abgesetzte Verbindungsbereich vom inneren Gehäuserahmen zum äußeren Gehäuserahmen hin abfallend geneigt ist, d.h., sich in negativer z-Richtung absenkt, und die Neigung dabei ca. 9° beträgt.

Bei einer weiteren vorteilhaften Ausgestaltung der Erfindung ist der abgesetzte Verbindungsbereich mit dem äußeren Gehäuserahmen senkrecht zur Ebene der Montagefläche auf Höhe einer Verbindungshöhe verbunden, wobei die Verbindungshöhe und/oder der Stützabschnitt im Bereich eines Schwingungsknotens des äußeren Gehäuserahmens bei einer durch Bonden angeregten Schwingung des äußeren Gehäuserahmens angeordnet ist.

Die Verbindungshöhe ist somit insbesondere jene Position bzw. jener Bereich in z-Richtung, auf welcher bzw. an welchem der abgesetzte Verbindungsbereich mit dem äußeren Gehäuserahmen verbunden ist.

Dieser Ausgestaltung liegt insbesondere die Erkenntnis zugrunde, dass in vielen Beispielen vor allem der äußere Gehäuserahmen zu Schwingungen angeregt wird, wenn bei der Herstellung des Leistungsmoduls Bondverbindungen hergestellt werden. Bspw. kann die Montagefläche mit auf der Montagefläche angeordneten elektrischen Bauteilen, bspw. Leistungshalbleitern, mittels Bonden bzw. einer Ultraschallverbindungstechnik elektrisch verbunden werden oder kann die Montagefläche mit den Anschlussflächen der Anschlusspins mittels Bonden elektrisch verbunden werden. Bei den genannten Schwingungen kann der äußere Gehäuserahmen jeweils im Bereich der erläuterten kurzen Seite insbesondere in Richtung zum inneren Gehäuserahmen schwingen. Der schwingende, äußere Gehäuserahmen weist dabei einen oder mehrere Schwingungsknoten, d. h. Bereiche mit einer Schwingungsamplitude null, und einen oder mehrere Schwingungsbäuche auf, d. h. Bereiche mit einer maximalen Schwingungsamplitude. Die Schwingung kann dabei durch die Anbindung des äußeren Gehäuserahmens an die Bodenplatte bzw. den Kühlkörper beeinflusst werden, so dass sich durch die genannte Anbindung die Lage des/r Schwingungsknoten(s) ändern kann.

Die vorliegende Ausgestaltung sieht nun vor, dass die erläuterte Verbindungshöhe im Bereich eines Schwingungsknoten des äußeren Gehäuserahmens angeordnet ist. Dies bewirkt, dass selbst wenn der äußere Gehäuserahmen während der Herstellung von Bondverbindungen zu Schwingungen in Richtung der Montagefläche angeregt wird, diese Schwingungen von dem äußeren Gehäuserahmen nicht bzw. nur noch unwesentlich über den abgesetzten Verbindungsbereich und den inneren Gehäuserahmen an die Bonddrähte bzw. die gebondeten, elektrischen Verbindungen übertragen wird. Deshalb kann die vorliegende Ausgestaltung erheblich dazu beitragen, eine sichere und dauerhafte Verbindung von gebondeten, elektrischen Verbindungen innerhalb des Leistungsmoduls zu erleichtern.

Alternativ oder zusätzlich sieht die vorliegende Ausgestaltung vor, dass der oben erläuterte Stützabschnitt im Bereich eines Schwingungsknoten des äußeren Gehäuserahmens angeordnet ist. Auch dadurch kann die Übertragung von Schwingungen des äußeren Gehäuserahmens, welche durch die Herstellung von Bondverbindungen angeregt werden können, über den abgesetzten Verbindungsbereich, ggf. den Stützabschnitt und die Bodenplatte, und den inneren Gehäuserahmen an die Bonddrähte bzw. die gebondeten, elektrischen Verbindungen verhindert bzw. verringert werden.

Die Anordnung der Verbindungshöhe bzw. des Stützabschnitts im Bereich eines Schwingungsknotens kann dabei insbesondere gegeben sein, wenn die Verbindungshöhe bzw. der Stützabschnitt bis zu 10%, insbesondere bis 5% oder bis zu 3%, der Wellenlänge der durch das Bonden auftretenden Schwingung von dem Schwingungsknoten entfernt angeordnet ist. Dadurch ist die Amplitude der Schwingung 21 im Bereich der Verbindungshöhe bzw. des Stützabschnitts noch vergleichsweise klein, so dass eine sichere und dauerhafte Verbindung von gebondeten, elektrischen Verbindungen innerhalb des Leistungsmoduls noch ausreichend sicher gewährleistet werden kann.

Die Wellenlänge der während des Bondens bzw. des Verbindens mittels einer Ultraschallverbindungstechnik auftretenden Schwingung kann dabei beispielsweise bei einem äußeren Gehäuserahmen aus Kunststoff und einer Frequenz von 50 kHz etwa 6 cm betragen.

Vorzugsweise ist die oben erläuterte Neigung so gewählt, dass der abgesetzte Verbindungsbereich beim inneren Gehäuserahmen in z-Richtung auf Höhe der jeweiligen Bondfläche bzw. der Anschlusspin-Kontaktfläche beginnt. Beim äußeren Gehäuserahmen bzw. beim Stützabschnitt endet der abgesetzte Verbindungsbereich in z-Richtung insbesondere auf Höhe der Erstreckung des Stützabschnitts in negativer z-Richtung, also bspw. auf Höhe des Berührpunktes des Stützabschnitts auf der Bodenplatte bzw. auf dem Kühlkörper. Bspw. ist die Neigung des abgesetzten Verbindungsbereichs vom inneren Gehäuserahmen bis zum äußeren Gehäuserahmen bzw. zum Stützabschnitt konstant, so dass die Neigung vom inneren Gehäuserahmen zum äußeren Gehäuserahmen entsprechend passend gewählt wird.

Bei einer weiteren vorteilhaften Ausgestaltung der Erfindung erstrecken sich der äußere Gehäuserahmen und optional der innere Gehäuserahmen im Bereich der kurzen Seite senkrecht zur Ebene der Montagefläche betrachtet in zumindest eine Richtung, vorzugsweise in beide Richtungen, über den jeweiligen abgesetzten Verbindungsbereich hinaus.

Insbesondere befindet sich somit die oben erläuterte, obere Kante des äußeren Gehäuserahmens im Bereich der kurzen Seite in positiver z-Richtung weiter oben als der jeweilige abgesetzte Verbindungsbereich. Zusätzlich kann sich weiterhin die oben erläuterte, untere Kante des äußeren Gehäuserahmens im Bereich der kurzen Seite in negativer z-Richtung weiter unten als der jeweilige abgesetzte Verbindungsbereich befinden. Dabei entspricht die Richtung senkrecht zur Ebene der Montagefläche der z-Richtung, welche senkrecht zur oben erläuterten x-y-Ebene ausgerichtet ist.

Bei einer weiteren vorteilhaften Ausgestaltung der Erfindung weist der Verbindungsbereich mehrere, in einer Richtung senkrecht zur Ebene der Montagefläche aus dem Verbindungsbereich herausragende Dome, insb. zum Halten der Montagefläche, auf.

In manchen Beispielen kann der Verbindungsbereich, insbesondere auch der abgesetzte Verbindungsbereich einen oder mehrere Dome aufweisen, die in positiver oder negativer z-Richtung aus dem übrigen Verbindungsbereich herausragen. Bspw. können die Dome zum Halten der Montagefläche oder als Befestigungspunkte des Leistungsmoduls innerhalb des elektrischen Geräts vorgesehen sein.

Für die übrige Ausgestaltung des Verbindungsbereichs und insbesondere des abgesetzten Verbindungsbereichs können die Dome in vielen Beispielen außer Acht gelassen werden. Dies gilt insbesondere bei der oben erläuterten Erstreckung des abgesetzten Verbindungsbereichs in z-Richtung.

Bei einer weiteren vorteilhaften Ausgestaltung der Erfindung weist das Gehäuse zumindest zwei elektrische Anschlüsse auf.

Beispielsweise kann das Leistungsmodul zur Wandlung einer (dreiphasigen) Wechselspannung in eine oder mehrere Gleichspannungen bzw. umgekehrt vorgesehen sein. Dazu weist das Gehäuse eine entsprechende Anzahl an elektrischen Anschlüssen in Form von Wechselspannungsanschlüssen und Gleichspannungsanschlüssen auf. Alternativ kann das Leistungsmodul zur Wandlung einer (dreiphasigen) Wechselspannung in eine andere (dreiphasige) Wechselspannung oder auch zur Wandlung einer Gleichspannung in eine andere Gleichspannung vorgesehen sein, wozu das Leistungsmodul entsprechende elektrische Anschlüsse aufweist. Entsprechend kann das elektrische Gerät, welches zumindest ein derartiges Leistungsmodul aufweist, als Gleichrichter, Wechselrichter oder Umrichter ausgestaltet sein.

Bei einer weiteren vorteilhaften Ausgestaltung der Erfindung ist die Montagefläche mittels Bonden bzw. einer Ultraschallverbindungstechnik mit zumindest einem, von dem Leistungsmodul umfassten Anschlusspin und/oder mit zumindest einem, von dem Leistungsmodul umfassten elektrischen Bauteil, insbesondere zumindest einem Leistungshalbleiter, elektrisch verbunden.

Beispielsweise kann die Montagefläche somit mittels einem oder mehreren Bonddrähten mit dem jeweiligen Anschlusspin und/oder mit dem jeweiligen elektrischen Bauteil durch Bonden oder eine Ultraschallverbindungstechnik elektrisch verbunden werden. Bspw. kann das jeweilige elektrische Bauteil als Leistungshalbleiter, insbesondere als Transistor, z.B. als Leistungs-MOSFET (englisch: metal oxide semiconductor fieldeffect transistor bzw. deutsch: Metall-Oxid-Halbleiter-Feldeffekttransistor) oder als IGBT (englisch: insulated-gate bipolar transistor bzw. deutsch: Bipolartransistor mit isolierter Gate-Elektrode), etc., oder als Diode ausgestaltet sein.

Bei einer weiteren vorteilhaften Ausgestaltung der Erfindung ist das Leistungsmodul mit einer elektrischen Leistung von zumindest mehreren 1 kW, vorzugsweise 40 kW bis 500 kW, mit einer Wechselspannung von zumindest mehreren 10 V, vorzugsweise 280 V bis 800 V, mit einer Gleichspannung von zumindest mehreren 100 V, vorzugsweise 800 V bis 1500 V, und/oder elektrischen Strömen von mehreren 1 A, vorzugsweise 70 A bis 1000 A, betreibbar.

Im Folgenden wird die Erfindung anhand der in den Figuren dargestellten Ausführungsbeispiele näher beschrieben und erläutert. Es zeigen:
- FIGs 1-10: ein erstes bis zehntes Ausführungsbeispiel des vorgeschlagenen Gehäuses,
- FIG 11: ein Ausführungsbeispiel des vorgeschlagenen Leistungsmoduls und
- FIG 12: ein Ausführungsbeispiel des vorgeschlagenen elektrischen Geräts.

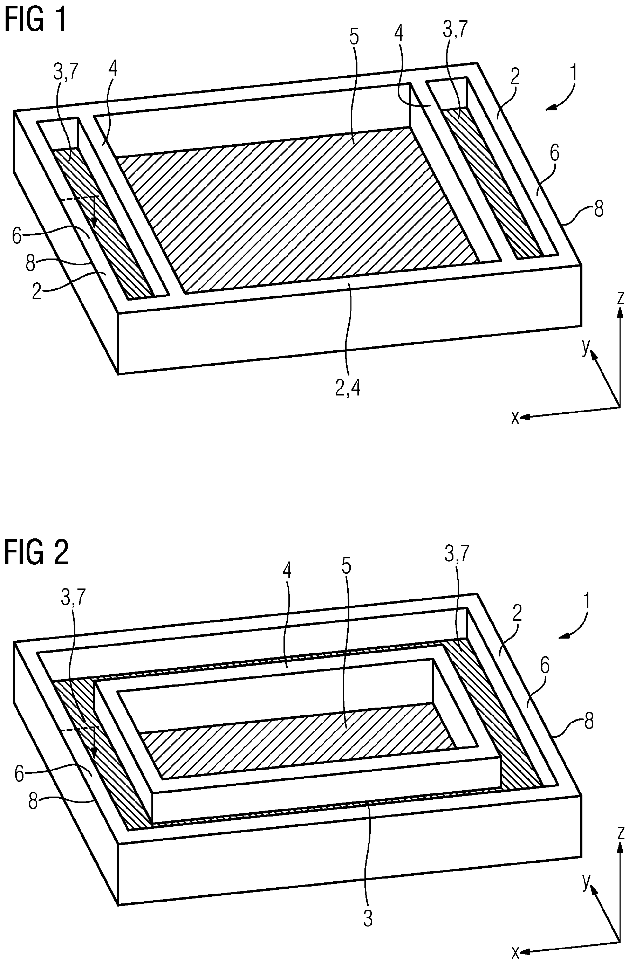

Die Figur 1 zeigt ein erstes Ausführungsbeispiel des vorgeschlagenen Gehäuses 1, wobei eine schematische, perspektivische Ansicht dargestellt ist.

Das Gehäuse 1 weist einen äußeren Gehäuserahmen 2, einen Verbindungsbereich 3 und einen inneren Gehäuserahmen 4 auf. Dabei ist das Gehäuse 1 bei einer Draufsicht im Wesentlichen rechteckig ausgestaltet. Somit weist das Gehäuse 5 zwei sich gegenüberliegende kurze Seiten 6 und zwei sich gegenüberliegende lange Seiten auf. Weiterhin ist der innere Gehäuserahmen 4 zur Aufnahme und zum zumindest teilweisen Einhausen einer Montagefläche 5 ausgebildet. Bspw. kann die Montagefläche 5 hierzu im Wesentlichen als Platte ausgestaltet sein, welche insbesondere bei einer Draufsicht eine im Wesentlichen rechteckige Gestalt haben kann.

Der äußere Gehäuserahmen 2 ist außerhalb des inneren Gehäuserahmens 4 angeordnet und dabei über den Verbindungsbereich 3 mit dem inneren Gehäuserahmen 4 verbunden. Wie in der Figur 1 abgebildet, können der äußere Gehäuserahmen 2, der Verbindungsbereich 3 und der innere Gehäuserahmen 4 abschnittsweise, nämlich bspw. im Bereich der langen Seiten, ineinander übergehen bzw. identisch sein. Insbesondere im Bereich der jeweiligen kurzen Seite 6 sind der äußere Gehäuserahmen 2, der Verbindungsbereich 3 und der innere Gehäuserahmen 4 separat ausgebildet.

Im Bereich der jeweiligen kurzen Seite 6 weist der Verbindungsbereich 3 dabei einen abgesetzten Verbindungsbereich 7 auf. Bei einer Draufsicht auf das Gehäuse 1 ist der abgesetzte Verbindungsbereich 7 dabei unterhalb der obere Kante 8 des äußeren Gehäuserahmens 2 (wiederum im Bereich der jeweiligen kurzen Seite 6) angeordnet, was in der Figur 1 durch einen Pfeil angedeutet wird.

Zur Veranschaulichung sind in Figur 1 die drei Achsen eines kartesischen Koordinatensystems eingezeichnet. Ohne Beschränkung der Allgemeinheit kann die Montagefläche 5 die x-y-Ebene aufspannen. Dann erstreckt sich der äußere Gehäuserahmen 2 im Bereich der jeweiligen kurzen Seite 6 insb. in z-Richtung, wobei die Oberseite der Montagefläche 5 in positiver z-Richtung weist und die Unterseite der Montagefläche 5 in negativer z-Richtung weist. Bei einer Draufsicht auf das Gehäuse 1 ist der abgesetzte Verbindungsbereich 7 somit in z-Richtung unterhalb der obere Kante 8 des äußeren Gehäuserahmens 2 angeordnet.

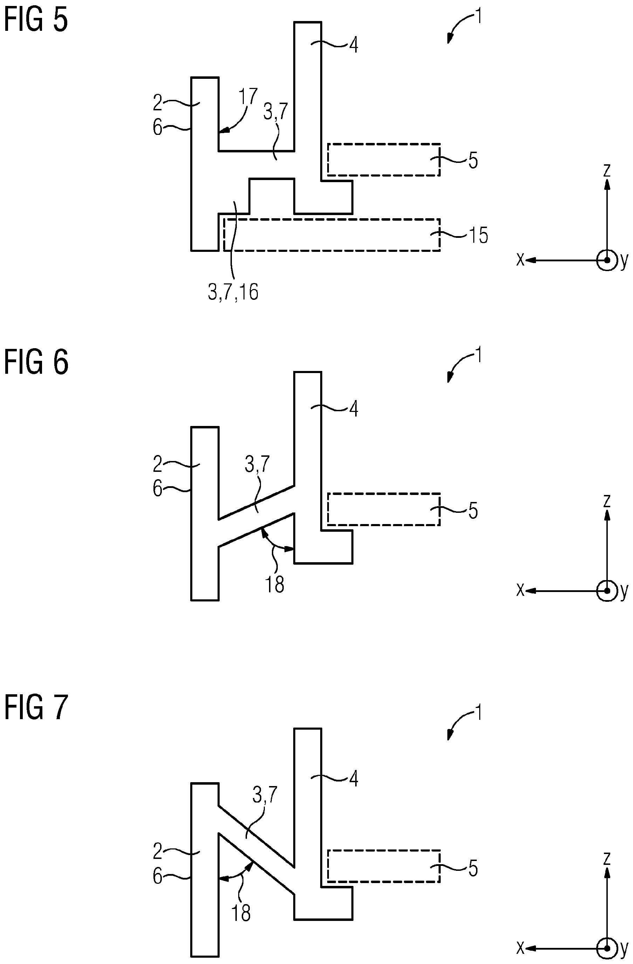

In einigen Beispielen ist der jeweilige abgesetzte Verbindungsbereich 7 dabei vom inneren Gehäuserahmen 4 zum äußeren Gehäuserahmen 2 hin bei einer Draufsicht auf die Montagefläche 5 zumindest abschnittsweise abfallend oder ansteigend geneigt. Die Neigung des jeweiligen abgesetzten Verbindungsbereichs 7 kann insbesondere zwischen 3° und 30°, bspw. ca. 9°, betragen. Ein geneigter, abgesetzter Verbindungsbereich 7 wird genauer in den Figuren 6 bis 10 und der zugehörigen Figurenbeschreibung dargestellt und erläutert.

Die Figur 2 zeigt ein zweites Ausführungsbeispiel des vorgeschlagenen Gehäuses 1, wobei wiederum eine schematische, perspektivische Ansicht dargestellt ist. Gleiche Bezugszeichen wie in Figur 1 bezeichnen dabei gleiche Gegenstände.

Im Unterschied zum ersten Ausführungsbeispiel sind gemäß dem zweiten Ausführungsbeispiel des vorgeschlagenen Gehäuses 1 der äußere Gehäuserahmen 2, der Verbindungsbereich 3 und der innere Gehäuserahmen 4 stets separat ausgebildet, d.h. auch im Bereich der langen Seiten.

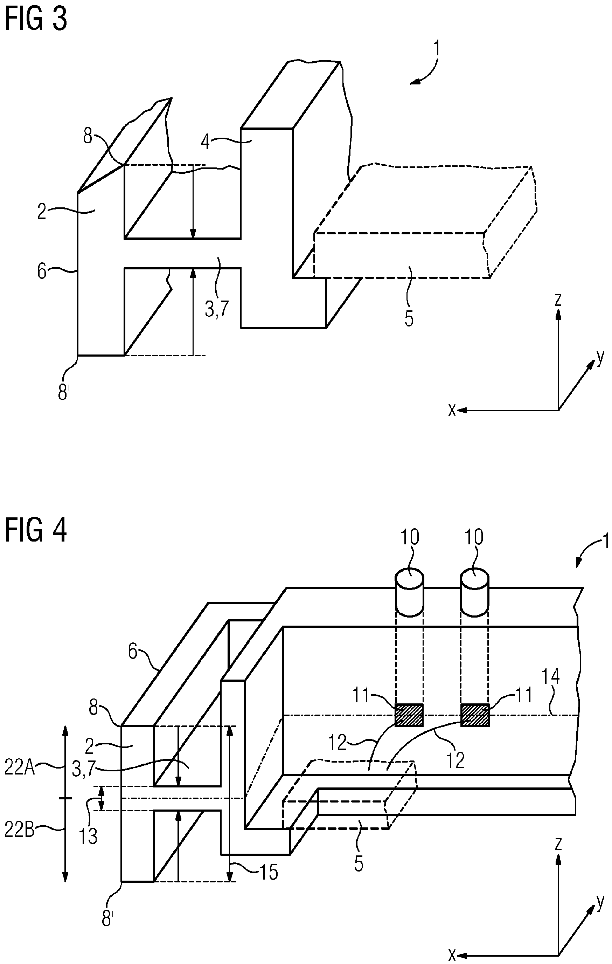

Die Figur 3 zeigt ein drittes Ausführungsbeispiel des vorgeschlagenen Gehäuses 1, wobei ein Querschnitt durch einen Ausschnitt des Gehäuses 1 dargestellt ist.

Das dritte Ausführungsbeispiel weist einige Ähnlichkeiten mit dem ersten und dem zweiten Ausführungsbeispiel auf. Wie gut in Figur 2 zu erkennen ist, ist der abgesetzte Verbindungsbereich 7 im Bereich der kurzen Seite 6 in z-Richtung bei einer Draufsicht unterhalb der oberen Kante 8 des äußeren Gehäuserahmens 2 angeordnet. Zusätzlich ist der abgesetzte Verbindungsbereich 7 dort auch oberhalb der unteren Kante 8' des äußeren Gehäuserahmens 2 angeordnet. Dies wird in Figur 3 durch zwei entsprechende Pfeile angedeutet.

Darüber hinaus kann der abgesetzte Verbindungsbereich 7 im Bereich der kurzen Seite 6 auch zwischen einer oberen Kante und unteren Kante des inneren Gehäuserahmens 4 angeordnet sein, wie in Figur 3 angedeutet. Weiterhin kann der innere Gehäuserahmen 4 einen Vorsprung aufweisen, welcher zur Montagefläche 5 weist und auf welchem die einzubringende Montagefläche 5 aufliegen kann.

Die Figur 4 zeigt ein viertes Ausführungsbeispiel des vorgeschlagenen Gehäuses 1, wobei wiederum ein Querschnitt durch einen Ausschnitt des Gehäuses 1 dargestellt ist.

Das vierte Ausführungsbeispiel weist einige Ähnlichkeiten mit den drei bereits erläuterten Ausführungsbeispielen auf. Gemäß dem vierten Ausführungsbeispiel weist das Gehäuse 1 zwei Anschlusspins 10 auf. Die Anschlusspins 10 sind dabei im Gehäuse 1 im Bereich der langen Seite angeordnet und in z-Richtung ausgerichtet. An ihrem unteren Ende (d. h. an ihrem in negativer z-Richtung befindlichen Ende) weisen Anschlusspins 10 jeweils eine Anschlusspin-Kontaktfläche 11 auf mittels welcher der jeweilige Anschlusspin 10 elektrisch kontaktiert werden kann. Insbesondere kann der jeweilige Anschlusspin 10 dabei mittels eines jeweiligen Bonddrahtes 12 und mittels Bonden bzw. einer Ultraschallverbindungstechnik mit der Montagefläche 5 verbunden werden.

Die jeweiligen Anschlusspin-Kontaktflächen 11 sind dabei auf einer Höhe 14 angeordnet, wobei sich die Höhe 14 auf die Ebene der Montagefläche 5 bezieht, es sich also um eine Höhe in z-Richtung handelt. Dabei soll der abgesetzte Verbindungsbereich 7 in einem Höhenbereich 13 (wiederum in z-Richtung) um die genannte Höhe 14 herum angeordnet sein.

Beispielsweise beträgt der Höhenbereich 13 ± 20 mm oder ± 10 mm, sodass der abgesetzte Verbindungsbereich 7 bspw. bis zu 20 mm oder 10 mm höher oder tiefer in z-Richtung als die Höhe 14 der jeweiligen Anschlusspin-Kontaktfläche 11 angeordnet sein kann bzw. sich erstrecken kann. In manchen Beispielen erstreckt sich der Höhenbereich 13 über drei Viertel oder bspw. ein Viertel der Erstreckung 15 des äußeren Gehäuserahmens 2 in einer Richtung 22A, 22B senkrecht zur Ebene der Montagefläche 5, d.h. über drei Viertel oder bspw. ein Viertel der Erstreckung 15 des äußeren Gehäuserahmens 2 in z-Richtung.

Die Figur 5 zeigt ein fünftes Ausführungsbeispiel des vorgeschlagenen Gehäuses 1, wobei wiederum ein Querschnitt durch einen Ausschnitt des Gehäuses 1 dargestellt ist.

Gemäß dem fünften Ausführungsbeispiel ist das Gehäuse 1 zur Aufnahme einer Bodenplatte bzw. eines Kühlkörpers 15 ausgebildet, welche/r bei einer Draufsicht unterhalb des Verbindungsbereichs 3 und des inneren Gehäuserahmens 4 angeordnet werden kann. Das Gehäuse 1 weist dabei am jeweiligen, abgesetzten Verbindungsbereich 7 einen Stützabschnitt 16 auf, welcher die Bodenplatte bzw. den Kühlkörper 15 berühren kann bzw. mit dieser/m verbunden ist, wobei die Bodenplatte bzw. den Kühlkörper 15 damit in z-Richtung fixieren werden kann.

Gemäß dem fünften Ausführungsbeispiel ist der jeweilige Stützabschnitt 16 dabei an jenem Ende 17 des abgesetzten Verbindungsbereichs 7 angeordnet, welches dem äußeren Gehäuserahmen 2 zugewandt ist. Bei dem verwendeten kartesischen Koordinatensystem ist der jeweilige Stützabschnitt 16 somit am Ende in x-Richtung des abgesetzten Verbindungsbereichs 7 angeordnet.

Die Figur 6 zeigt ein sechstes Ausführungsbeispiel des vorgeschlagenen Gehäuses 1, wobei wiederum ein Querschnitt durch einen Ausschnitt des Gehäuses 1 dargestellt ist.

Gemäß dem sechsten Ausführungsbeispiel ist der abgesetzte Verbindungsbereich 7 vom inneren Gehäuserahmen 4 zum äußeren Gehäuserahmen 2, d. h. in Figur 6 entlang der positiven x-Richtung, bei einer Draufsicht auf die Montagefläche 5 in z-Richtung abfallend geneigt. Dabei liegt eine abfallende Neigung 18 vor, wenn der entlang der x-Richtung ausgerichtete, abgesetzte Verbindungsbereich 7 in der Figur 6 vom inneren Gehäuserahmen 4 aus betrachtet nach unten bzw. entgegen dem Uhrzeigersinn geneigt ist.

Vorzugsweise beträgt die Neigung 18 zwischen 3° und 30°, bspw. ca. 9°.

Die Figur 7 zeigt ein siebtes Ausführungsbeispiel des vorgeschlagenen Gehäuses 1, wobei wiederum ein Querschnitt durch einen Ausschnitt des Gehäuses 1 dargestellt ist.

Im Gegensatz zu dem sechsten Ausführungsbeispiel ist der abgesetzte Verbindungsbereich 7 gemäß dem siebten Ausführungsbeispiel vom inneren Gehäuserahmen 4 zum äußeren Gehäuserahmen 2, d. h. in Figur 7 entlang der positiven x-Richtung, bei einer Draufsicht auf die Montagefläche 5 in z-Richtung ansteigend geneigt. Das bedeutet insbesondere, dass der entlang der x-Richtung ausgerichtete, abgesetzte Verbindungsbereich 7 in der Figur 7 vom inneren Gehäuserahmen 4 aus betrachtet nach oben bzw. im Uhrzeigersinn geneigt ist.

Vorzugsweise beträgt die Neigung 18 zwischen 3° und 30°, bspw. ca. 9°.

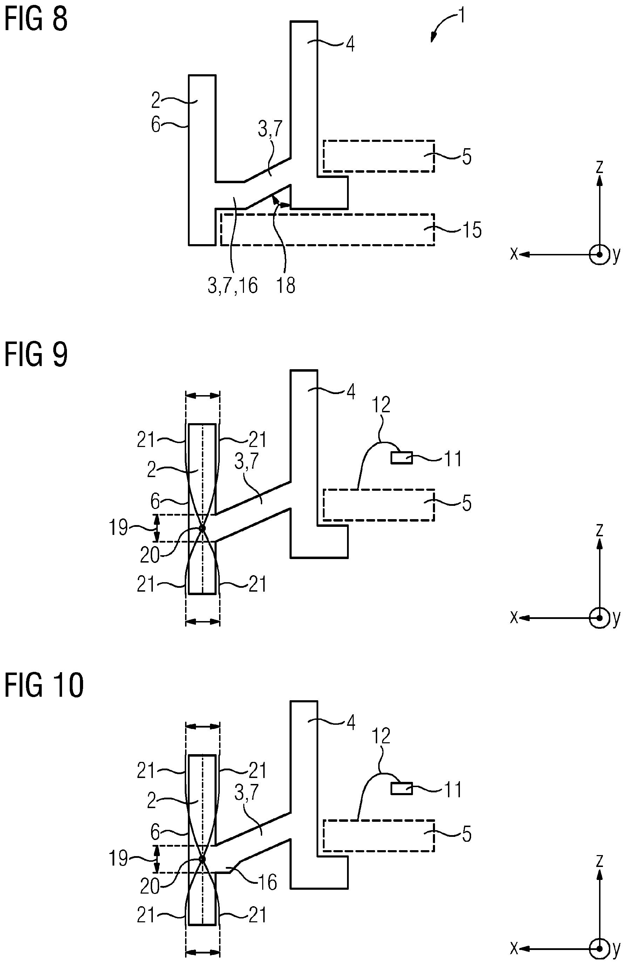

Die Figur 8 zeigt ein achtes Ausführungsbeispiel des vorgeschlagenen Gehäuses 1, wobei wiederum ein Querschnitt durch einen Ausschnitt des Gehäuses 1 dargestellt ist.

Das achte Ausführungsbeispiel kombiniert einige Aspekte des sechsten und des siebten Ausführungsbeispiels. So weist das Gehäuse 1 am jeweiligen, abgesetzten Verbindungsbereich 7 den Stützabschnitt 16 auf, welcher die Bodenplatte bzw. den Kühlkörper 15 berühren kann und die Bodenplatte 15 damit in z-Richtung fixieren kann. Weiterhin ist der abgesetzte Verbindungsbereich 7 vom inneren Gehäuserahmen 4 zum äußeren Gehäuserahmen 2, d. h. in Figur 8 entlang der positiven x-Richtung, bei einer Draufsicht auf die Montagefläche 5 in z-Richtung abfallend geneigt.

Die Figur 9 zeigt ein neuntes Ausführungsbeispiel des vorgeschlagenen Gehäuses 1, wobei wiederum ein Querschnitt durch einen Ausschnitt des Gehäuses 1 dargestellt ist.

Gemäß dem neunten Ausführungsbeispiel ist der abgesetzte Verbindungsbereich 7 mit dem äußeren Gehäuserahmen 2 auf Höhe einer bestimmten Verbindungshöhe 19 verbunden, wobei die Verbindungshöhe 19 eine Höhe senkrecht zur Ebene der Montagefläche 5 und somit eine Höhe in z-Richtung ist. Die Verbindungshöhe 19 ist dabei im Bereich eines Schwingungsknotens 20 des äußeren Gehäuserahmens 2 bei einer durch Bonden angeregten Schwingung 21 des äußeren Gehäuserahmens 2 angeordnet. Die Anordnung der Verbindungshöhe 19 im Bereich eines Schwingungsknotens 20 kann dabei insbesondere gegeben sein, wenn die Verbindungshöhe 19 bis zu 10%, insbesondere bis 5% oder bis zu 3%, der Wellenlänge der durch das Bonden auftretenden Schwingung von dem Schwingungsknoten 20 entfernt angeordnet ist.

Bei der Herstellung des Leistungsmoduls können bspw. die in Figur 4 dargestellten und erläuterten Bonddrähte 11 mittels Bonden bzw. mittels einer Ultraschallverbindungstechnik mit der jeweiligen Anschlusspin-Kontaktfläche 11 oder der Montagefläche 5 elektrisch verbunden werden. Während des Bondens bzw. Verbindens können dabei Schwingungen angeregt werden, die auch den äußeren Gehäuserahmen 2 in die Schwingung 21 versetzen, wobei die Schwingung 21 des äußeren Gehäuserahmens 2 einen oder mehrere Schwingungsknoten 20 mit der Schwingungsamplitude null und einen oder mehrere Schwingungsbäuche mit der maximalen Schwingungsamplitude aufweisen kann. Gemäß dem neunten Ausführungsbeispiel wird der abgesetzte Verbindungsbereich 7 im Bereich eines solchen Schwingungsknoten des mit dem äußeren Gehäuserahmen 2 verbunden.

Vorzugsweise ist der abgesetzte Verbindungsbereich 7 dabei vom inneren Gehäuserahmen 4 zum äußeren Gehäuserahmen 2, d. h. in Figur 9 entlang der positiven x-Richtung, bei einer Draufsicht auf die Montagefläche 5 in z-Richtung abfallend geneigt, wie in Figur 9 ebenfalls dargestellt. Dabei handelt es sich jedoch um ein optionales Merkmal, sodass der abgesetzte Verbindungsbereich 7 auch ansteigend geneigt sein kann oder nicht geneigt sein kann.

Die Figur 10 zeigt ein zehntes Ausführungsbeispiel des vorgeschlagenen Gehäuses 1, wobei wiederum ein Querschnitt durch einen Ausschnitt des Gehäuses 1 dargestellt ist.

Das zehnte Ausführungsbeispiel des vorgeschlagenen Gehäuses 1 weist einige Ähnlichkeiten mit dem neunten Ausführungsbeispiel auf. Der abgesetzte Verbindungsbereich 7 weist den Stützabschnitt 16 auf, welcher gemäß dem zehnten Ausführungsbeispiel im Bereich eines Schwingungsknotens 20 des äußeren Gehäuserahmens 2 bei einer durch Bonden angeregten Schwingung 21 des äußeren Gehäuserahmens 2 angeordnet ist. Die Anordnung des Stützabschnitts 16 im Bereich eines Schwingungsknotens 20 kann dabei insbesondere gegeben sein, wenn der Stützabschnitt 16 bis zu 10%, insbesondere bis 5% oder bis zu 3%, der Wellenlänge der durch das Bonden auftretenden Schwingung von dem Schwingungsknoten 20 entfernt angeordnet ist.

Weiterhin kann der abgesetzte Verbindungsbereich 7 mit dem äußeren Gehäuserahmen 2 auf Höhe der Verbindungshöhe 19 verbunden sein, wie in Figur 10 dargestellt. Die Verbindungshöhe 19 kann dabei ebenfalls im Bereich eines Schwingungsknotens 20 des äußeren Gehäuserahmens 2 bei einer durch Bonden angeregten Schwingung 21 des äußeren Gehäuserahmens 2 angeordnet sein, wie im Zusammenhang mit der Figur 9 bereits erläutert.

Vorzugsweise ist der abgesetzte Verbindungsbereich 7 dabei vom inneren Gehäuserahmen 4 zum äußeren Gehäuserahmen 2, d. h. in Figur 10 entlang der positiven x-Richtung, bei einer Draufsicht auf die Montagefläche 5 in z-Richtung abfallend geneigt, wie in Figur 10 ebenfalls dargestellt. Dabei handelt es sich jedoch um ein optionales Merkmal, sodass der abgesetzte Verbindungsbereich 7 auch ansteigend geneigt sein kann oder nicht geneigt sein kann.

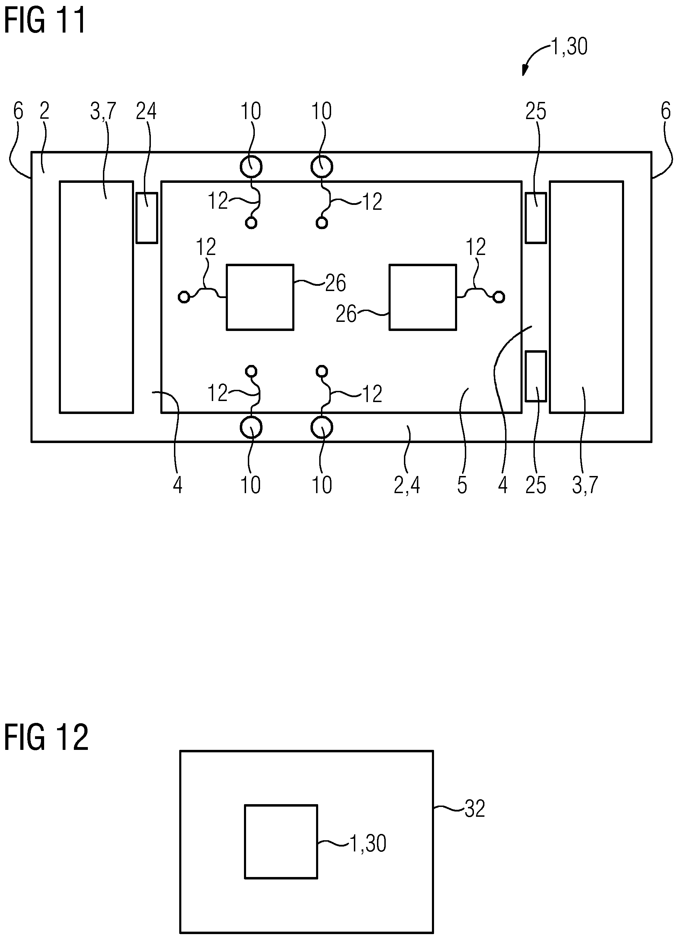

Die Figur 11 zeigt ein Ausführungsbeispiel des vorgeschlagenen Leistungsmoduls 30, wobei eine Draufsicht auf das Leistungsmodul 30 dargestellt ist.

Das Leistungsmodul 30 weist ein Gehäuse 1 mit einem elektrischen Anschluss 24, bspw. für eine Wechselspannung, sowie zwei weitere elektrische Anschlüsse 25 auf, bspw. für zwei unterschiedliche Gleichspannungen. Auf der Montagefläche 5 sind zwei elektrische Bauteile 26 angeordnet, welche bspw. als IGBTs ausgestaltet sein können. Die beiden elektrischen Bauteile 26 sind dabei über Bonddrähte 12 mit der Montagefläche 5 verbunden. Weiterhin ist die Montagefläche 5 mittels Bonddrähten 12 mit den Anschlusspins 10 verbunden, die in das Gehäuse 1 eingebracht sind.

Die Figur 12 zeigt ein Ausführungsbeispiel des vorgeschlagenen elektrischen Gerätes 32, wobei eine schematische Ansicht dargestellt ist.

Das elektrische Gerät zur 32 kann bspw. als Umrichter, Gleichrichter oder Wechselrichter ausgestaltet sein und weist zumindest ein Leistungsmodul 30 auf.

## Patentansprüche

1. Gehäuse (1) für ein Leistungsmodul (30),
wobei das Gehäuse (1) bei einer Draufsicht im Wesentlichen rechteckig ausgestaltet ist und einen äußeren Gehäuserahmen (2), einen Verbindungsbereich (3) und einen inneren Gehäuserahmen (4) aufweist,
wobei der innere Gehäuserahmen (4) zur Aufnahme und zum zumindest teilweisen Einhausen einer Montagefläche (5) für zumindest ein elektrisches Bauteil (26) des Leistungsmoduls (30) ausgebildet ist und
wobei der äußere Gehäuserahmen (2) außerhalb des inneren Gehäuserahmens (4) angeordnet ist und über den Verbindungsbereich (3) mit dem inneren Gehäuserahmen (4) verbunden ist, **dadurch gekennzeichnet, dass**
der Verbindungsbereich (3) im Bereich der jeweiligen kurzen Seite (6) jeweils einen abgesetzten Verbindungsbereich (7) aufweist, welcher bei einer Draufsicht unterhalb der oberen Kante (8) des äußeren Gehäuserahmens (2) im Bereich der jeweiligen kurzen Seite (6) angeordnet ist.

2. Gehäuse (1) nach Anspruch 1,
wobei der abgesetzte Verbindungsbereich (7) bei einer Draufsicht oberhalb der unteren Kante (8') des äußeren Gehäuserahmens (2) im Bereich der jeweiligen kurzen Seite (6) angeordnet ist.

3. Gehäuse (1) nach einem der vorhergehenden Ansprüche,
wobei das Gehäuse (1) mehrere Anschlusspins (10) aufweist, wobei der jeweilige Anschlusspin (10) an seinem unteren Ende eine jeweilige Anschlusspin-Kontaktfläche (11) aufweist, über welche der jeweilige Anschlusspin (10) mittels eines Bonddrahtes (12) bzw. mittels einer Ultraschallverbindungstechnik mit der Montagefläche (5) verbindbar ist, und
wobei der abgesetzte Verbindungsbereich (7) jeweils senkrecht zur Ebene der Montagefläche (5) betrachtet überwiegend in einem Höhenbereich (13) um die Höhe (14) der jeweiligen Anschlusspin-Kontaktfläche (11) angeordnet ist.

4. Gehäuse (1) nach Anspruch 3,
wobei der Höhenbereich (13) ± 20 mm, insb. ± 10 mm oder ± 5 mm, beträgt und/oder
wobei sich der Höhenbereich (13) über drei Viertel, insb. die Hälfte oder ein Viertel, der Erstreckung (15) des äußeren Gehäuserahmens (2) in einer Richtung (22A, 22B) senkrecht zur Ebene der Montagefläche (5) erstreckt.

5. Gehäuse (1) nach einem der vorhergehenden Ansprüche,
wobei das Gehäuse (1) bei einer Draufsicht unterhalb des Verbindungsbereichs (3) und des inneren Gehäuserahmens (4) zur Aufnahme einer Bodenplatte bzw. eines Kühlkörpers (15) ausgebildet ist und
wobei der jeweilige abgesetzte Verbindungsbereich (7) einen Stützabschnitt (16) aufweist, welcher die aufgenommene Bodenplatte bzw. den aufgenommenen Kühlkörper (15) berührt bzw. mit dieser oder diesem verbunden ist.

6. Gehäuse (1) nach Anspruch 5,
wobei der jeweilige Stützabschnitt (16) an jenem Ende (17) des abgesetzten Verbindungsbereichs (7) angeordnet ist, welches dem äußeren Gehäuserahmen (2) zugewandt ist.

7. Gehäuse (1) nach einem der vorhergehenden Ansprüche,
wobei der jeweilige abgesetzte Verbindungsbereich (7) vom inneren Gehäuserahmen (4) zum äußeren Gehäuserahmen (2) bei einer Draufsicht auf die Montagefläche (5) zumindest abschnittsweise abfallend oder ansteigend geneigt ist.

8. Gehäuse (1) nach Anspruch 7,
wobei die Neigung (18) des jeweiligen abgesetzten Verbindungsbereichs (7) zwischen 3° und 30°, vorzugsweise zwischen 5° und 15°, insbesondere ca. 9°, beträgt.

9. Gehäuse (1) nach einem der vorhergehenden Ansprüche, insbesondere nach Anspruch 5 oder 6,
wobei der abgesetzte Verbindungsbereich (7) mit dem äußeren Gehäuserahmen (2) senkrecht zur Ebene der Montagefläche (5) auf Höhe einer Verbindungshöhe (19) verbunden ist und
wobei die Verbindungshöhe (19) und/oder der Stützabschnitt (16) im Bereich eines Schwingungsknotens (20) des äußeren Gehäuserahmens (2) bei einer durch Bonden bzw. eine Ultraschallverbindungstechnik angeregten Schwingung (21) des äußeren Gehäuserahmens (2) angeordnet ist.

10. Gehäuse (1) nach einem der vorhergehenden Ansprüche,
wobei sich der äußere Gehäuserahmen (2) und optional der innere Gehäuserahmen (4) im Bereich der kurzen Seite (6) senkrecht zur Ebene der Montagefläche (5) betrachtet in zumindest eine Richtung (22A), vorzugsweise in beide Richtungen (22A, 22B), über den jeweiligen abgesetzten Verbindungsbereich (7) hinaus erstrecken.

11. Gehäuse (1) nach einem der vorhergehenden Ansprüche,
wobei das Gehäuse (1) zumindest zwei Spannungsanschlüsse (24, 25) aufweist.

12. Leistungsmodul (30) aufweisend
- ein Gehäuse (1) nach einem der vorhergehenden Ansprüche und
- eine Montagefläche (5) für zumindest ein elektrisches Bauteil (26), wobei die Montagefläche (5) durch den inneren Gehäuserahmen (4) aufgenommen und zumindest teilweise eingehaust wird.

13. Leistungsmodul (30) nach Anspruch 12,
wobei die Montagefläche (5) mittels einer Ultraschallverbindungstechnik mit zumindest einem, von dem Leistungsmodul (30) umfassten Anschlusspin (10) und/oder mit zumindest einem, von dem Leistungsmodul (30) umfassten elektrischen Bauteil (26), insbesondere zumindest einem Leistungshalbleiter, elektrisch verbunden ist.

14. Leistungsmodul (30) nach Anspruch 12 oder 13,
wobei das Leistungsmodul (30) mit einer elektrischen Leistung von zumindest mehreren 1 kW, vorzugsweise 40 kW bis 500 kW, mit einer Wechselspannung von zumindest mehreren 10 V, vorzugsweise 280 V bis 800 V, mit einer Gleichspannung von zumindest mehreren 10 V, vorzugsweise 800 V bis 1500 V, und/oder elektrischen Strömen von mehreren 1 A, vorzugsweise 70 A bis 1000 A, betreibbar ist.

15. Elektrisches Gerät (32), insbesondere Umrichter, umfassend zumindest ein Gehäuse (1) nach einem der Ansprüche 1 bis 11 und/oder zumindest ein Leistungsmodul (30), vorzugsweise zumindest drei Leistungsmodule (30), nach einem der Ansprüche 11 bis 14.
